# FASCICULE DE BREVET EUROPEEN

(11) **EP 3 840 145 B1**
(45) Date de publication et mention de la délivrance du brevet: **07.09.2022**
(21) Numéro de dépôt: 20214561.1
(22) Date de dépôt: 16.12.2020
(51) Int. Cl.: H02B 1/56, H05K 5/02, H05K 7/18

(54) **ARMOIRE ÉLECTRIQUE AVEC UNE ISOLATION THERMIQUE ET PROCÉDÉ DE GESTION D'UNE TELLE ARMOIRE**
ELEKTRISCHER SCHALTSCHRANK MIT EINER WÄRMEDÄMMUNG, UND VERFAHREN ZUR STEUERUNG EINES SOLCHEN SCHALTSCHRANKS
ELECTRICAL CABINET WITH THERMAL INSULATION AND METHOD FOR CONTROLLING SUCH A CABINET

(30) Priorité: 17.12.2019 FR 1914687
(43) Date de publication de la demande: 23.06.2021
(73) Titulaire: Schneider Electric Industries SAS, 92500 Rueil-Malmaison (FR)
(72) Inventeur: PERRIN, Alain, 38000 GRENOBLE (FR); LOPEZ, Josep, 38000 GRENOBLE (FR)
(74) Mandataire: Lavoix

(56) Documents cités:
- WO-A1-99/08354
- WO-A1-2019/128165
- WO-A2-2009/132639

## Description

La présente invention concerne une armoire électrique avec une isolation thermique, ainsi qu'un procédé de gestion de cette armoire électrique.

Les armoires électriques comprennent généralement une enceinte, dans laquelle sont logés divers appareils électriques. Ces appareils peuvent être, de façon non limitative, des appareils de protection électrique ou de distribution d'électricité, des automates industriels ou des équipements informatiques, et bien d'autres exemples encore. Ces appareils sont sensibles aux températures trop froides ou trop chaudes, et requièrent, pour fonctionner correctement, un milieu régulé en température. Ces appareils sont également très sensibles à l'humidité et tolèrent mal l'accumulation d'humidité ou de condensation à l'intérieur de l'armoire.

Lorsque les armoires électriques sont installées à l'extérieur des bâtiments et sont exposées aux aléas météorologiques, les températures au sein des armoires électriques, généralement métalliques, peuvent atteindre des valeurs extrêmes en hiver ou en été, et le coût énergétique lié à la climatisation des armoires est important.

Il est connu de couvrir une armoire électrique d'une couverture isolante, réalisée par exemple en panneaux de polystyrène expansé ou de tout autre matériau adapté, de manière à réduire les transferts de chaleur entre l'intérieur et l'extérieur de l'armoire électrique, ce qui réduit le coût énergétique de la climatisation.

Cependant, en particulier aux périodes d'intersaisons, les cycles quotidiens de température et l'humidité de l'air liée aux précipitations ont tendance à favoriser l'apparition de condensation au sein des armoires, qui endommage de façon prématurée les appareils électriques logés dans l'armoire. Les couvertures isolantes connues n'ont que peu d'impact pour réduire l'apparition de la condensation. Il est certes possible de rajouter un appareil dédié au séchage de l'air, cependant cet appareil de séchage engendre des couts d'installation et d'exploitation supplémentaires, ce qui n'est pas toujours souhaitable.

WO-2019/128165-A1 décrit une armoire électrique avec des panneaux à double parois, intégrant des films chauffants. Les films chauffants engendrent des couts d'installation et d'exploitation supplémentaires, ce qui n'est pas toujours souhaitable.

C'est à ces problèmes qu'entend plus particulièrement remédier l'invention, en proposant une armoire électrique permettant une isolation thermique satisfaisante, de structure simple, qui est économe en énergie et qui limite l'apparition de condensation à l'intérieur de l'armoire.

À cet effet, l'invention concerne une armoire électrique avec une isolation thermique. L'armoire électrique définit une enceinte pour recevoir au moins un appareil électrique et comporte au moins une paroi thermiquement isolante montée sur une face de l'armoire électrique. Selon l'invention, la paroi isolante comporte une cavité interne creuse, alors que l'armoire électrique comporte en outre un dispositif mécanique, tel qu'un compresseur ou une pompe, configuré pour modifier la pression à l'intérieur de ladite cavité, le dispositif mécanique étant fluidiquement connecté à ladite cavité. L'armoire électrique comporte au moins un dispositif de mesure, configuré pour déterminer une différence de température entre l'intérieur de l'armoire et l'extérieur de l'armoire. L'armoire électrique comprend aussi un dispositif électronique de commande, configuré pour piloter le dispositif mécanique de manière à modifier la pression à l'intérieur de ladite cavité en fonction de la différence de température mesurée.

Grâce à l'invention, la conductivité thermique de la paroi isolante est ajustable en changeant la pression intérieure de la cavité grâce au dispositif mécanique. Un tel système présente une structure particulièrement simple dans son principe avec une fiabilité élevée. Lorsque le dispositif de mesure enregistre une température extrême à l'extérieur de l'armoire, le dispositif électronique de commande actionne le dispositif mécanique de façon à abaisser la pression intérieure jusqu'à une valeur basse, pour réduire la conductivité thermique de la paroi isolante et ainsi réduire les transferts de chaleur entre l'intérieur et l'extérieur de l'armoire. Lorsque les conditions régnant à l'intérieur de l'armoire risquent d'engendrer de la condensation, la pression à l'intérieur de la cavité est ajustée par le dispositif de commande, en prenant en compte les mesures provenant du dispositif de mesure, de manière à réduire les risques de condensation.

Selon des aspects avantageux mais non obligatoires de l'invention, une telle armoire électrique peut incorporer une ou plusieurs des caractéristiques suivantes prises selon toute combinaison techniquement admissible :
- le dispositif mécanique est configuré pour soutirer ou introduire un gaz ou un mélange de gaz dans la cavité interne ;
- le dispositif mécanique est configuré pour introduire un gaz ou un mélange de gaz dans la cavité interne à une pression supérieure à la pression atmosphérique ;
- le dispositif de mesure comporte un premier capteur de température pour mesurer la température extérieure à l'armoire électrique, et un deuxième capteur de température pour mesurer la température intérieure de l'armoire électrique ;
- le dispositif de mesure comporte un capteur d'humidité apte à mesurer l'humidité relative à l'intérieur de l'enceinte, le dispositif de commande étant configuré pour piloter le dispositif mécanique de manière à modifier la pression à l'intérieur de la cavité interne en fonction également de l'humidité relative mesurée ;
- la paroi isolante est placée sur une face supérieure de l'armoire, notamment pour recouvrir au moins en partie ladite face supérieure ;
- la paroi isolante s'étend d'un seul tenant sur au moins une partie de la périphérie de l'armoire électrique, de façon à couvrir plusieurs faces adjacentes de l'armoire électrique ;
- l'armoire électrique comporte au moins deux parois thermiquement isolantes, chacune associée à une face de l'armoire électrique, les deux parois isolantes étant reliées par un connecteur qui connecte fluidiquement les cavités internes respectives desdites parois isolantes, l'une desdites cavités étant connectée fluidiquement au même dispositif mécanique ou à des dispositifs mécaniques séparés ;
- l'armoire électrique comporte au moins deux parois thermiquement isolantes, chacune associée à une face de l'armoire électrique, les cavités internes respectives desdites parois isolantes étant chacune connectée fluidiquement à un dispositif mécanique ;
- le gaz contenu dans la cavité interne est de l'air, et
- le gaz contenu dans la cavité interne est un mélange de gaz avec des coefficients de conductivité thermique différents.

L'invention concerne également un procédé de pilotage d'une armoire électrique tel que décrit précédemment, qui comprend les étapes consistant à :
a) acquérir les mesures en provenance du dispositif de mesure ;
b) analyser les mesures grâce au dispositif électronique de commande et calculer une réponse ;
c) soutirer ou introduire de l'air dans la cavité interne de la paroi isolante grâce au dispositif mécanique.

Selon des aspects avantageux mais non obligatoires de l'invention, un tel procédé de pilotage peut incorporer une ou plusieurs des caractéristiques suivantes prises selon toute combinaison techniquement admissible :
- à l'étape b) précédente, lorsque la température mesurée par le capteur externe de température extérieure est supérieure à un premier seuil ou inférieure à un deuxième seuil, le deuxième seuil étant strictement inférieur au premier seuil, alors à l'étape c) le dispositif mécanique soutire de l'air de la cavité interne de la paroi isolante (6) ;
- à l'étape b) précédente, lorsque la température mesurée par le capteur externe de température extérieure est comprise entre le premier seuil et le deuxième seuil, si dans une première sous-étape la température extérieure est supérieure à la température intérieure, ou bien si dans une deuxième sous-étape des conditions propices à l'apparition de condensation dans l'enceinte sont détectées, alors à l'étape c) le dispositif mécanique soutire de l'air de la cavité interne de la paroi isolante.

L'invention sera mieux comprise et d'autres avantages de celle-ci apparaîtront plus clairement à la lumière de la description qui va suivre, de quatre modes de réalisation d'une armoire électrique et d'un procédé de gestion de cette armoire électrique conformes à son principe, donnée uniquement à titre d'exemple et faite en référence aux dessins annexés, dans lesquels :
- [Fig 1] la figure 1 est une vue schématique d'une armoire électrique conforme à un premier mode de réalisation de l'invention ;
- [Fig 2] la figure 2 représente schématiquement, sur trois inserts notés (a), (b) et (c), une armoire électrique conforme respectivement à un deuxième, troisième et quatrième mode de réalisation de l'invention ;
- [Fig 3] la figure 3 est un logigramme représentant un procédé de gestion de l'isolation thermique pour une armoire électrique conforme à des modes de réalisation de l'invention, et
- [Fig 4] la figure 4 est un logigramme représentant un cas particulier du procédé de gestion de l'isolation thermique conforme à l'invention.

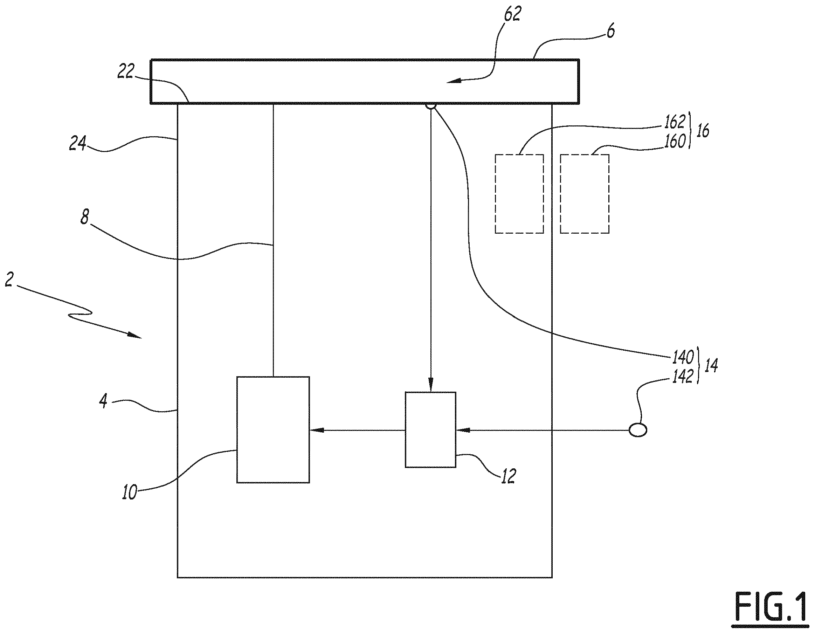

Une armoire électrique 2 est représentée sur la figure 1.

L'armoire électrique 2 définit une enceinte 4, prévue pour recevoir un ou plusieurs appareils électriques. Les appareils électriques ne sont pas représentés et incluent, selon les cas, des appareils de protection électriques, de distribution d'électricité, des automates industriels ou des équipements informatiques.

L'enceinte 4 est généralement fermée, et protège les appareils électriques des intrusions intempestives. Lorsque l'armoire électrique 2 est située à l'extérieur, l'enceinte 4 protège aussi les appareils électriques des intempéries.

L'armoire électrique 2 comprend au moins une paroi thermiquement isolante 6, montée sur une face de l'armoire électrique 2.

Dans la présente description, sauf mention spécifique, les termes « isolant » ou « conducteur » sont à comprendre au sens de « thermiquement isolant » ou « thermiquement conducteur », et non pas au sens d'électriquement isolant ou d'électriquement conducteur.

Dans l'exemple illustré sur la figure 1, l'armoire électrique 2 présente une forme géométrique de prisme ou de pavé à base parallélépipédique. L'armoire 2 est ici posée sur une surface horizontale et comporte une face supérieure 22 et des faces latérales 24. La paroi isolante 6 est ici associée à la paroi supérieure 22 de l'armoire électrique 2, et forme par exemple un toit de l'armoire électrique 2.

Selon d'autres exemples, la paroi isolante 6 peut être montée sur une des faces latérales 24 de l'enceinte 4.

Selon d'autres exemples, l'enceinte 4 est une enceinte fermée, comportant des parois montées sur une armature de l'armoire 2, et la paroi thermiquement isolante 6 est rapportée sur l'enceinte 4.

Selon d'autres exemples encore, l'enceinte 4 comprend une structure telle qu'une armature, non représentée, sur laquelle la paroi isolante 6 est montée.

La paroi isolante 6 comporte une cavité interne 62 qui est creuse. La cavité interne 62 est fluidiquement connectée, par l'intermédiaire d'un conduit 8, à un dispositif mécanique 10.

Le dispositif mécanique 10 est par exemple un compresseur ou une pompe et est configuré pour modifier la pression à l'intérieur de la cavité interne 62 par l'intermédiaire du conduit 8.

Selon des exemples, la cavité interne 62 est remplie d'un gaz, tel que de l'air, et le dispositif mécanique 10 est une pompe à air, apte à soutirer de l'air de la cavité interne 62, de manière à abaisser la pression interne de la cavité interne 62.

Selon des exemples, le dispositif mécanique est une pompe réversible, c'est-à-dire que le dispositif mécanique 10 est apte à soutirer du gaz hors de la cavité interne 62 et, alternativement, à introduire un gaz dans la cavité interne 62, par l'intermédiaire du conduit 8, ou alternativement de plusieurs conduits. En particulier, le dispositif mécanique 10 peut être réversible de sorte à pouvoir, en plus, sélectivement introduire dans la cavité 62 un gaz à une pression supérieure à la pression atmosphérique.

Dans de nombreux modes de réalisation, notamment ceux décrits ci-après, le gaz est de l'air, notamment de l'air ambiant.

Toutefois, dans des variantes non décrites en détail, le gaz peut être différent, par exemple un gaz inerte tel que de l'argon.

Selon d'autres exemples, le dispositif mécanique 10 inclut une vanne, non représentée, qui est configurée pour, lorsque la vanne est ouverte, relier la cavité interne 62 à l'atmosphère du milieu extérieur, la cavité interne 62 étant alors remplie d'air à pression atmosphérique.

Selon des exemples, ladite vanne est combinée au dispositif mécanique 10 au sein d'un même appareil. La vanne peut être une électrovanne.

Selon des exemples, la vanne est séparée du dispositif mécanique 10 et est reliée à la cavité interne 62 par un conduit spécifique, non représenté, qui est distinct du conduit 8 représenté sur la figure 1.

L'armoire électrique 2 comprend, en outre, un dispositif électronique de commande 12, qui est configuré pour piloter le dispositif mécanique 10 de manière à modifier la pression à l'intérieur de la cavité interne 62 de la paroi isolante 6.

Selon des modes de réalisation, le dispositif électronique de commande 12 comporte une unité logique de calcul (CPU), telle qu'un microcontrôleur programmable ou un microprocesseur ou équivalent, et une mémoire informatique formant un support d'enregistrement de données lisibles par ordinateur.

Selon des exemples, la mémoire est une mémoire ROM, ou une mémoire RAM, ou une mémoire non volatile du type EPROM ou FLASH ou équivalent. La mémoire comporte des instructions exécutables et/ou du code informatique pour assurer le fonctionnement du dispositif de commande 12 conformément à un ou plusieurs des modes de réalisation décrits ci-après lorsqu'exécuté par l'unité logique de calcul.

Le dispositif de commande 12 est relié à un dispositif de mesure 14, qui est par exemple au moins apte à déterminer une différence de température entre l'intérieur de l'armoire électrique 2 et l'extérieur de l'armoire électrique 2.

Le dispositif de mesure 14 comprend ici un capteur interne 140, qui mesure la température intérieure de l'armoire électrique 2, c'est-à-dire la température à l'intérieur de l'enceinte 4, et un capteur externe 142, qui mesure la température extérieure à l'armoire électrique 2, c'est-à-dire la température à l'extérieur de l'enceinte 4.

Dans l'exemple illustré, le capteur interne 140 mesure la température de la paroi isolante 6 à l'intérieur de l'enceinte 4, tandis que le capteur externe 142 mesure la température de l'air à l'extérieur de l'enceinte 4.

Selon des exemples, le capteur interne 140 est aussi configuré pour mesurer l'humidité relative à l'intérieur de l'enceinte 4. Par exemple, le capteur interne 140 comporte un capteur d'humidité. Le capteur de température et le capteur d'humidité du capteur interne 140 peuvent être intégrés au sein d'un même module, ou être implémentés par deux capteurs séparés placés en des emplacements différents de l'enceinte 4.

L'humidité relative, notée HR%, correspond au ratio entre la quantité de vapeur d'eau contenue dans un volume d'air à une température donnée par rapport à la capacité maximale de vapeur d'eau que ce volume d'air peut contenir à la même température. Lorsque l'humidité relative HR% est égale à 0%, l'air est considéré comme étant sec, tandis que lorsque l'humidité relative HR% est égale à 100%, l'air est saturé en humidité, et ne peut contenir plus de vapeur d'eau ; toute quantité d'eau supplémentaire est sous forme liquide.

Le dispositif électronique de commande 12 est ainsi configuré pour piloter le dispositif mécanique 10 en fonction de la différence de température mesurée entre les capteurs interne 140 et externe 142.

Selon des exemples, le dispositif de commande 12 est configuré pour piloter le dispositif mécanique 10 en fonction également de l'humidité relative HR% mesurée par le capteur interne 140.

Optionnellement, l'armoire électrique 2 peut en outre comporter un dispositif de conditionnement 16 de l'air, qui comprend ici une unité de refroidissement 160 et une unité de chauffage 162. Par exemple, l'unité de refroidissement 160 comporte une climatisation à cycle de compression et détente de fluide, ou un module à effet Peltier, ou équivalent, tandis que l'unité de chauffage 162 comporte des résistances chauffantes, ou équivalent.

Les unités de refroidissement 160 et de chauffage 162 sont ici dessinés en pointillés car le dispositif de conditionnement 16, même s'il est souvent rencontré dans les armoires électriques 2, n'est pas indispensable à la réalisation de l'invention.

Selon des exemples, l'unité de refroidissement 160 est située à l'extérieur de l'enceinte 4, tandis que l'unité de chauffage 162 est située à l'intérieur de l'enceinte 4. Selon d'autres exemples, les unités de refroidissement et de chauffage 160 et 162 sont combinées au sein d'un même appareil, tel qu'une pompe à chaleur, qui comprend alors une unité interne et une unité externe à l'enceinte 4. Le dispositif de conditionnement 16 comprend généralement des capteurs de température, non représentés, et le dispositif de conditionnement peut être indépendant du dispositif de commande 12. Selon d'autres exemples, le dispositif de conditionnement est piloté par le dispositif de commande 12.

On décrit à présent le fonctionnement de la paroi isolante 6.

Lorsque le dispositif mécanique 10 soutire de l'air de la cavité interne 62, la pression à l'intérieur de la cavité interne 62 décroit. Il est d'autre part connu que la conductivité thermique de l'air est liée au choc des molécules d'air entre-elles. De façon schématique, lorsque la pression diminue, la quantité de molécules d'air au sein d'un volume donné décroit, la probabilité de choc entre les molécules d'air décroit aussi et la conductivité thermique de l'air décroit. La conductivité thermique d'un matériau est généralement exprimée par une grandeur intensive, dont l'unité est le Watt par mètre-Kelvin, notée aussi W·m⁻¹K⁻¹ ou W/(mK).

Autour de la pression atmosphérique, par exemple entre 0,5 bar et 4 bars, la conductivité thermique peut être considérée comme proportionnelle à la pression de l'air, tandis que dans un domaine de basse pression, en particulier dans un domaine de vide partiel, la relation entre la pression de l'air et la conductivité thermique n'est pas linéaire. Ainsi, lorsque la pression de l'air décroit en deçà d'une pression dite « de coupure », la conductivité thermique de l'air décroit brutalement sous une valeur de conductivité minimale, par exemple inférieure à une conductivité thermique de 0,004 W/(mK). À titre d'illustration, une telle valeur de 0,004 W/(mK) est environ huit à dix fois inférieure à la conductivité thermique d'isolants thermiques traditionnels tel que le polystyrène expansé ou la laine de roche.

On comprend donc que lorsque le dispositif mécanique 10 soutire de l'air jusqu'à ce que la pression à l'intérieur de la cavité interne 62 soit inférieure à la pression de coupure, la conductivité thermique de la paroi isolante 6 est minimale.

Dans le cadre de la présente description, par « soutire de l'air », on entend que le dispositif mécanique 10 soutire de la cavité interne 62 une quantité d'air pouvant être prédéfinie, cette quantité d'air étant préférentiellement choisie telle que la pression à l'intérieur de la cavité interne 62 atteigne une valeur inférieure à la pression de coupure.

Selon des exemples optionnels, un dispositif de mesure de la pression au sein au sein de la cavité interne 62 peut être prévu pour réguler le fonctionnement du dispositif mécanique 10. Ce dispositif de mesure de pression, non illustré, peut être intégré ou séparé du dispositif mécanique 10.

À l'inverse, lorsque le dispositif mécanique 10 introduit de l'air dans la cavité interne 62, la pression à l'intérieur de la cavité interne 62 dépasse la pression de coupure et la conductivité thermique au sein de la cavité interne 62 est bien supérieure à la valeur de la conductivité thermique lorsque la pression interne est inférieure à la pression de coupure. À titre d'illustration, la conductivité thermique de l'air sec à pression atmosphérique est de l'ordre de 0,026 W/mK.

L'introduction d'air dans la cavité interne 62 peut se faire au moyen du dispositif mécanique 10 lorsque ce dernier est réversible, ou bien simplement par l'ouverture d'une vanne, reliée d'un côté à la cavité interne 62 et reliée de l'autre côté à l'air libre. Ainsi, lorsque la vanne est ouverte, la pression à l'intérieur de la cavité interne 62 est égale à la pression atmosphérique, qui est bien supérieure à la pression de coupure.

On comprend donc que grâce au dispositif mécanique 10, la pression au sein de la cavité interne 62 est ajustable, et la conductivité thermique de la paroi isolante 6 est elle aussi ajustable.

Dans les modes de réalisation où le dispositif mécanique 10 est réversible, autrement dit configuré pour introduire dans la cavité 62 de l'air à une pression supérieure à la pression atmosphérique, l'amplitude d'ajustement de la conductivité thermique est supérieure aux cas où l'introduction d'air se fait au moyen d'une vanne reliée à l'air libre, car l'air sous pression présente une conductivité thermique supérieure à la conductivité thermique de l'air à la pression atmosphérique.

Sur l'exemple de la figure 1, la cavité interne 62 est creuse, c'est-à-dire qu'elle n'est remplie que de gaz.

Lorsque la pression à l'intérieur de la cavité interne 62 est inférieure à la pression atmosphérique, qui règne à l'extérieur de la cavité interne 62, les parois de la paroi isolante 6 ont tendance, sous l'effet de la différence de pression, à se rapprocher. Autrement dit, la paroi isolante 6 à tendance à s'écraser lorsque le dispositif mécanique 10 soutire de l'air de la cavité interne 62. La paroi isolante 6 est avantageusement conçue pour résister à cet écrasement, par exemple en choisissant un matériau présentant une résistance mécanique suffisante.

Avantageusement, un dispositif d'espacement est prévu au sein de la cavité interne 62 pour éviter l'écrasement de la paroi isolante 6 lorsque la pression interne diminue. À titre d'exemple non limitatif, le dispositif d'espacement peut comprendre des calles, ou bien un matériau poreux, de préférence à cellules ouvertes, ce matériau poreux étant avantageusement isolant thermiquement lorsque la pression à l'intérieur de la cavité interne 62 est supérieure à la pression de coupure.

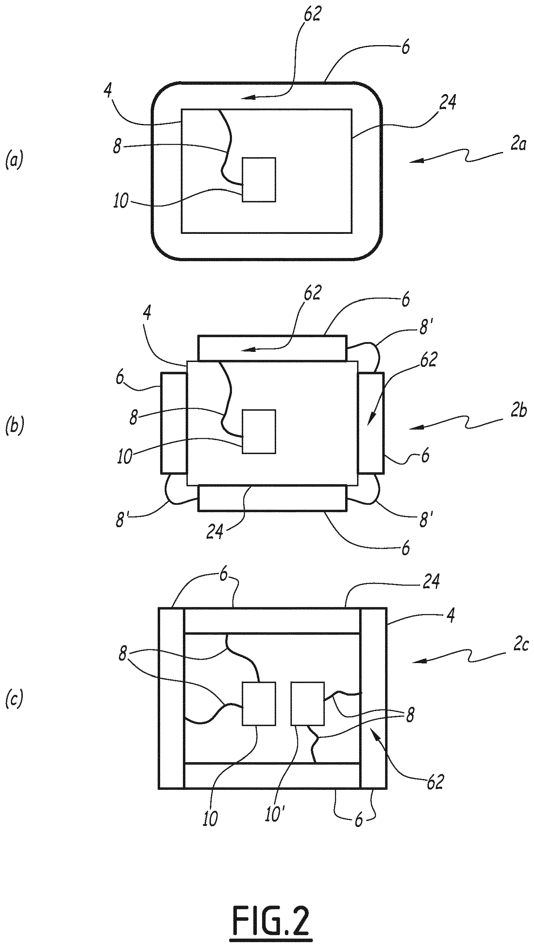

La figure 2 contient des inserts (a), (b) et (c), qui présentent des deuxième, troisième et quatrième modes de réalisation de l'armoire électrique, référencés respectivement 2a, 2b et 2c. Les éléments de ces armoires qui sont analogues à l'armoire 2 du premier mode de réalisation portent les mêmes références et fonctionnent de façon analogue. Dans ce qui suit, ont décrit principalement les différences entre les variantes représentées sur la figure 2 et les modes de réalisation représentées sur la figure 1.

Une armoire électrique 2a, conforme au deuxième mode de réalisation de l'invention, est représentée sur l'insert (a) de la figure 2. La paroi isolante 6 recouvre ici conjointement plusieurs faces adjacentes de l'armoire électrique 2a. Dans l'exemple illustré, la paroi isolante 6 recouvre quatre faces latérales 24 adjacentes de l'armoire électrique 2a.

Selon des exemples, la paroi isolante 6 recouvre deux faces 24 adjacentes de l'armoire électrique 2a. Selon d'autres exemples, la paroi isolante 6 recouvre trois faces 24 adjacentes de l'armoire électrique 2a. Plus généralement, on comprend que quelle que soit la forme de la paroi isolante 6, la cavité interne 62 est ménagée d'un seul tenant au sein de la paroi isolante 6 et est reliée par un conduit 8 au dispositif mécanique 10.

Une armoire électrique 2b conforme au troisième mode de réalisation de l'invention est représentée sur l'insert (b) de la figure 2.

L'armoire électrique 2b comprend plusieurs parois isolantes 6, chacune ménagée respectivement sur une face latérale 22 de l'enceinte 4.

Les parois isolantes 6 sont reliées entre elles par des connecteurs 8', qui connectent fluidiquement les cavités 62 respectives de deux parois isolantes 6 adjacentes. Ainsi une même pression règne à l'intérieur de toutes les cavités internes 62 connectées entre-elles par un connecteur 8'. Une des cavités 62 est fluidiquement connectée au dispositif mécanique 10 par l'intermédiaire du conduit 8, de façon à soutirer ou introduire de l'air conjointement dans toutes les cavités internes 62 qui sont reliées entre elles.

Plus généralement, on comprend que plusieurs parois isolantes 6 peuvent être disposées sur les faces de l'enceinte 4, y compris sur la face supérieure 22 de l'enceinte 4 telle que représentée sur la figure 1, les parois isolantes 6 étant ensuite reliées entre-elles par des connecteurs 8' et l'une des parois isolantes 6 étant reliée à un seul et même dispositif mécanique 10 par un conduit 8.

Une armoire électrique 2c conforme au quatrième mode de réalisation de l'invention est représentée sur l'insert (c) de la figure 2.

L'armoire électrique 2c comprend plusieurs parois isolantes 6, qui sont chacune associées à une face latérale 22 de l'enceinte 4 et sont ici situées à l'intérieur de l'enceinte 4. L'armoire électrique 2c comprend, en plus du dispositif mécanique 10, un deuxième dispositif mécanique 10', qui fonctionne de façon analogue au dispositif mécanique 10.

Dans l'exemple illustré, deux des parois isolantes 6 sont reliées par un premier conduit 8 respectif au dispositif mécanique 10, et deux autres des parois isolantes 6 sont reliées par un autre conduit 8 au dispositif mécanique 10'.

Plus généralement, on comprend que de nombreuses combinaisons des modes de réalisation des armoires électriques 2, 2a, 2b et 2c sont possibles, pour isoler les faces de l'enceinte 4 de l'intérieur ou de l'extérieur, les parois isolantes 6 étant connectées fluidiquement à un ou plusieurs dispositifs mécaniques du type du dispositif mécanique 10.

Le ou les dispositifs mécaniques 10 sont pilotés par un dispositif de commande 12, selon un procédé de gestion de l'isolation thermique que l'on décrit à présent.

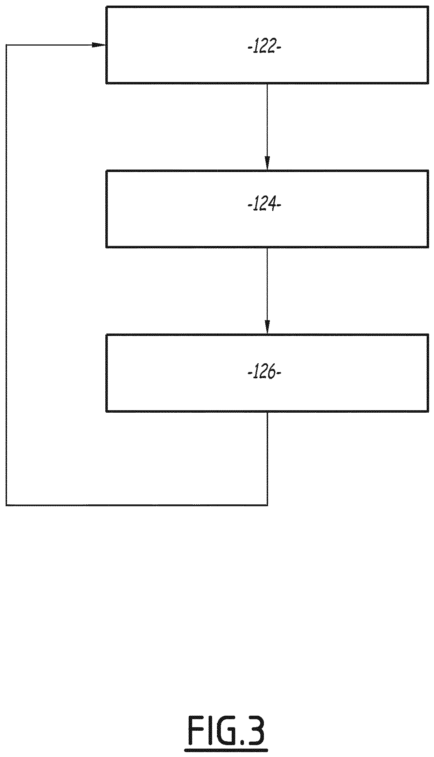

Sur la figure 3, le procédé de gestion de l'isolation thermique donné à titre d'exemple est représenté de façon schématique et comprend ici une étape 122, une étape 124, et une étape 126.

Au cours de l'étape 122, le dispositif électronique de commande 12 acquiert les différentes informations de températures intérieure, extérieure et le cas échéant d'humidité relative HR% intérieure grâce au dispositif de mesure 14.

Le dispositif de commande 12 est configuré pour analyser, lors de l'étape 124, les mesures enregistrées lors de l'étape 122, notamment pour identifier les conditions de température et d'humidité propices à l'apparition de condensation au sein de l'enceinte 4.

À titre d'exemple non limitatif, il est connu d'utiliser un diagramme enthalpique de la vapeur d'eau, dit aussi « diagramme de Mollier », qui permet d'identifier, en cas de refroidissement d'une masse d'air initialement à une température donnée et présentant une humidité relative donnée, la température à partir de laquelle la condensation commence à apparaître, autrement dit le point de rosée, ou « dew point » en anglais.

Le dispositif électronique de commande 12 calcule ainsi une réponse et envoie les instructions correspondantes au dispositif mécanique 10.

Au cours de l'étape 126, le dispositif mécanique 10 soutire ou introduit de l'air dans la cavité interne 62 de la paroi isolante 6 en fonction des instructions reçues du dispositif de commande 12.

Par exemple, lorsque la température externe, mesurée par le capteur externe 142, est élevée, par exemple supérieure à un premier seuil, ici égal à 35°C, ou à l'inverse lorsque la température extérieure est basse, par exemple inférieure à un deuxième seuil, strictement inférieur au premier seuil et ici égal à 10°C, le dispositif de conditionnement 16 est généralement activé pour conserver les équipements électriques de l'armoire 2 à une température moyenne de fonctionnement prédéfinie, le dispositif de conditionnement 16 étant alors consommateur de quantités importantes d'énergie. Il est alors avantageux de baisser la conductivité thermique des parois isolantes 6, en soutirant de l'air des cavités internes 62 des parois isolantes au moyen du dispositif mécanique 10.

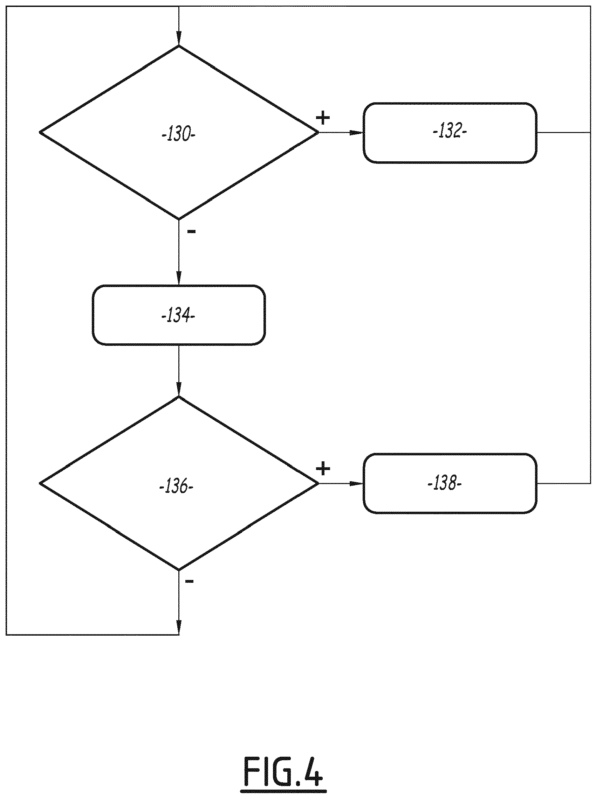

Le logigramme représenté sur la figure 4 correspond à une situation dans laquelle la température extérieure mesurée par le capteur externe 142 est comprise entre le premier seuil et le deuxième seuil, c'est-à-dire ici entre 10°C et 35°C.

Entre ces deux températures, en particulier lorsque la température quotidienne varie cycliquement, il arrive que la température externe soit supérieure à la température interne, ou l'inverse.

Comme décrit précédemment, les risques de condensation sont potentiellement élevés lorsqu'un air chaud et à l'humidité relative élevée est refroidi, en particulier lorsque l'air chaud et humide est mis au contact d'une paroi froide. Dans le cas de l'armoire électrique 2, la portion de l'enceinte 4 la plus susceptible de générer de la condensation est la face supérieure, autrement dit le toit de l'armoire 2, à l'intérieur de l'enceinte 4. Aussi le capteur interne 140 qui mesure la température interne est-il avantageusement placé au contact du toit au sein de l'enceinte 4, même si, comme expliqué précédemment, d'autres emplacements sont possibles en fonction des circonstances.

Au cours d'une sous-étape 130 du procédé, la température extérieure mesurée par le capteur externe 142 est comparée à la température intérieure mesurée par le capteur interne 140. Si la température extérieure est supérieure à la température intérieure, les risques que de la condensation se forme à l'intérieur de l'enceinte 4 sont considérés comme faibles car l'enceinte 4 a naturellement tendance à se réchauffer. En conséquence, au cours d'une sous-étape 132, le dispositif mécanique 10, commandé par le dispositif de commande 12, soutire de l'air de la cavité interne 62 de la paroi isolante 6, de manière à abaisser la conductivité thermique de la paroi isolante 6 et à retarder le réchauffement de l'enceinte 4.

Si, au cours de la sous-étape 130, la température extérieure est inférieure à la température intérieure, alors au cours d'une sous-étape 134, le dispositif de commande 12 pilote le dispositif mécanique 10 pour introduire de l'air au sein de la cavité interne 62.

Au cours d'une sous-étape 136 succédant à l'étape 134, les risques de condensation sont évalués par le dispositif de commande 12 en fonction, notamment, des températures intérieures, extérieures, et de l'humidité relative HR% à l'intérieur de l'enceinte 4, et par exemple suivant une loi de commande prédéfinie, par exemple enregistrée en mémoire du dispositif électronique de commande 12.

À titre illustratif, lorsque l'air à l'intérieur de l'enceinte 4 a une température de 21°C avec une humidité relative HR% de 50%, à l'aide du diagramme de Mollier, on comprend que l'humidité relative de cet air atteint 100% si la température de cet air est abaissée autour de 11°C. Autrement dit, si la température extérieure est inférieure ou égale à 11°C, alors l'enceinte 4 de l'armoire électrique 2, en particulier le toit de l'enceinte 4, risque de se refroidir à tel point que de la condensation risque d'apparaître à l'intérieur de l'enceinte 4. Il convient donc, pour retarder le refroidissement de la paroi de l'enceinte 4, de soutirer de l'air de la paroi isolante 6 afin d'en réduire la conductivité thermique, ce qui correspond à une sous-étape 138 de la figure 4.

À l'inverse, si les conditions de températures intérieure, extérieure et d'humidité relative HR% ne présentent qu'un risque faible de condensation au sein de l'enceinte 4, alors le dispositif de commande 12 revient à la sous-étape 130 décrite précédemment.

Bien entendu d'autres lois de commande peuvent être implémentées.

Notamment, les lois de commande et/ou les seuils de température et/ou d'humidité peuvent être choisis différemment si le gaz est autre chose que de l'air.

Le principe de procédé de gestion décrit ci-dessus n'est qu'un exemple possible parmi d'autres, et l'on comprend que d'autres procédés de gestion sont possibles pour optimiser la consommation énergétique de l'armoire électrique 2, notamment en lien avec le dispositif de conditionnement 16 s'il est présent, et pour réduire les risques de condensation au sein de l'enceinte 4.

Selon des exemples, les procédés de gestion de l'isolation peuvent utiliser plus de capteurs que dans l'exemple illustré, par exemple des capteurs d'ensoleillement, ou bien peuvent utiliser des informations relatives aux prévisions météorologiques, ces exemples n'étant pas limitatifs.

Dans les exemples illustrés, seules les parois isolantes 6 comprenant des cavités internes 62 sont montées sur l'enceinte 4. En variante non représentée, les parois isolantes 6 comprenant une cavité interne 62 peuvent être combinées avec des isolants traditionnels, par exemple pour assurer la continuité entre les parois isolantes 6 aux endroits de l'armoire électrique 2 présentant des formes complexes, tel que des angles ou des coins.

Dans les exemples illustrés, la cavité 62 est remplie d'air. Selon une variante non représentée, un gaz autre que de l'air, ou un mélange de plusieurs gaz, présentant des coefficients de conductivité thermique différents, peuvent être utilisés.

Il est par exemple possible d'utiliser un gaz qui présente un coefficient de conductivité thermique bas, tel que le krypton, dont la conductivité thermique est de l'ordre de 0,0088 W/m/K. Ainsi la paroi 6, avec une cavité 62 remplie d'un tel gaz à bas coefficient de conductivité thermique, présente des transferts thermiques inférieurs à ceux obtenus avec de l'air.

À l'inverse, il est possible d'utiliser un gaz présentant un coefficient de conductivité thermique plus élevé, tel que l'hélium, dont le coefficient de conductivité thermique est de l'ordre de 0,15 W/m/K. Ainsi la paroi 6, remplie d'un tel gaz, favorise les échanges thermiques par rapport à ceux de l'air.

L'homme du métier saura bien entendu choisir le gaz ou le mélange de gaz adaptés à l'application envisagée, en tenant compte notamment du coût, de la performance et de la facilité d'utilisation.

On comprend notamment que, au sens de la présente description, tout ce qui a été décrit précédemment en référence à « un » gaz est transposable à un mélange gazeux de plusieurs gaz.

Selon une autre variante non représentée, lorsqu'un gaz autre que de l'air est utilisé, un réservoir supplémentaire relié au dispositif mécanique peut être prévu, pour stocker le gaz lorsque le dispositif mécanique soutire le gaz de la cavité 62, le gaz étant soutiré du réservoir supplémentaire lorsque le dispositif mécanique introduit le gaz dans la cavité 62.

Le mode de réalisation et les variantes mentionnées ci-dessus peuvent être combiné entre eux pour générer de nouveaux modes de réalisation de l'invention.

## Revendications

1. Armoire électrique (2 ; 2a ; 2b ; 2c) avec une isolation thermique, l'armoire électrique définissant une enceinte (4) pour recevoir au moins un appareil électrique, ladite armoire électrique comportant au moins une paroi thermiquement isolante (6) montée sur une face (22 ; 24) de l'armoire électrique, ladite isolante comportant une cavité interne (62) creuse, **caractérisée en ce que** l'armoire électrique comporte en outre :
un dispositif mécanique (10 ; 10'), tel qu'un compresseur ou une pompe, configuré pour modifier la pression à l'intérieur de ladite cavité (62), le dispositif mécanique étant fluidiquement connecté à ladite cavité,
au moins un dispositif de mesure (14), configuré pour déterminer une différence de température entre l'intérieur de l'armoire et l'extérieur de l'armoire,
un dispositif électronique de commande (12), configuré pour piloter le dispositif mécanique (10 ; 10') de manière à modifier la pression à l'intérieur de ladite cavité (62) en fonction de la différence de température mesurée.

2. Armoire électrique (2 ; 2a ; 2b ; 2c) selon la revendication précédente, **caractérisée en ce que** le dispositif mécanique (10 ; 10') est configuré pour soutirer ou introduire un gaz ou un mélange de gaz dans la cavité interne (62).

3. Armoire électrique (2 ; 2a ; 2b ; 2c) selon la revendication précédente, **caractérisé en ce que** le dispositif mécanique (10, 10') est en outre configuré pour introduire un gaz ou un mélange de gaz dans la cavité interne (62) à une pression supérieure à la pression atmosphérique.

4. Armoire électrique (2 ; 2a ; 2b ; 2c) selon l'une quelconque des revendications précédentes, **caractérisée en ce que** le dispositif de mesure (14) comporte un premier capteur (142) de température pour mesurer la température extérieure à l'armoire électrique, et un deuxième capteur (140) de température pour mesurer la température intérieure de l'armoire électrique.

5. Armoire électrique (2 ; 2a ; 2b ; 2c) selon l'une quelconque des revendications précédentes, **caractérisée en ce que** le dispositif de mesure (14) comporte un capteur d'humidité (140) apte à mesurer l'humidité relative à l'intérieur de l'enceinte (4), et **en ce que** le dispositif de commande (12) est en outre configuré pour piloter le dispositif mécanique (10 ; 10') de manière à modifier la pression à l'intérieur de la cavité interne (62) en fonction également de l'humidité relative mesurée.

6. Armoire électrique (2) selon l'une quelconque des revendications précédentes, **caractérisée en ce que** la paroi isolante (6) est placée sur une face supérieure (22) de l'armoire, notamment pour recouvrir au moins en partie ladite face supérieure.

7. Armoire électrique (2a) selon l'une quelconque des revendications 1 à 6, **caractérisée en ce que** la paroi isolante (6) s'étend d'un seul tenant sur au moins une partie de la périphérie de l'armoire électrique, de façon à couvrir plusieurs faces (22 ; 24) adjacentes de l'armoire électrique.

8. Armoire électrique (2b) selon l'une quelconque des revendication 1 à 6, **caractérisée en ce que** l'armoire comporte au moins deux parois thermiquement isolantes (6), chacune associée à une face (22 ; 24) de l'armoire électrique, les deux parois isolantes étant reliées par un connecteur (8') qui connecte fluidiquement les cavités internes (62) respectives desdites parois isolantes, l'une desdites cavités étant connectée fluidiquement au même dispositif mécanique (10) ou à des dispositifs mécaniques séparés.

9. Armoire électrique (2c) selon l'une quelconque des revendication 1 à 6, **caractérisée en ce que** l'armoire comporte au moins deux parois thermiquement isolantes (6), chacune associée à une face (22 ; 24) de l'armoire électrique, les cavités internes (62) respectives desdites parois isolantes étant chacune connectée fluidiquement à un dispositif mécanique (10 ; 10').

10. Armoire électrique (2 ; 2a ; 2b ; 2c) selon l'une quelconque des revendications 2 à 9, **caractérisée en ce que** le gaz contenu dans la cavité interne (62) est de l'air.

11. Armoire électrique (2; 2a; 2b ; 2c) selon l'une quelconque des revendications 2 à 9, **caractérisée en ce que** le gaz contenu dans la cavité interne (62) est un mélange de gaz avec des coefficients de conductivité thermique différents.

12. Procédé de gestion de l'isolation thermique pour une armoire électrique (2 ; 2a ; 2b ; 2c) conforme à l'une quelconque des revendications précédentes, **caractérisé en ce que** le procédé de gestion de l'isolation comprend les étapes suivantes :
a) une première étape (122) consistant à acquérir les mesures en provenance du dispositif de mesure (14) ;
b) une deuxième étape (124) consistant à analyser les mesures grâce au dispositif électronique de commande (12) et calculer une réponse ;
c) une troisième étape (126) consistant à soutirer ou introduire de l'air dans la cavité interne (62) de la paroi isolante (6) grâce au dispositif mécanique (10 ; 10').

13. Procédé de gestion de l'isolation thermique selon la revendication précédente, **caractérisé en ce qu'**à la deuxième étape (124), lorsque la température mesurée par le capteur externe (142) de température extérieure est supérieure à un premier seuil ou inférieure à un deuxième seuil, le deuxième seuil étant strictement inférieur au premier seuil, alors à la troisième étape (126) le dispositif mécanique (10 ; 10') soutire de l'air de la cavité interne (62) de la paroi isolante (6).

14. Procédé de gestion de l'isolation thermique selon l'une quelconque des revendications 12 ou 13, **caractérisé en ce qu'**à la deuxième étape (124), lorsque la température mesurée par le capteur externe (142) de température extérieure est comprise entre le premier seuil et le deuxième seuil, si dans une première sous-étape (130) la température extérieure est supérieure à la température intérieure, ou bien si dans une deuxième sous-étape (136) des conditions propices à l'apparition de condensation dans l'enceinte (4) sont détectées, alors à la troisième étape (126) le dispositif mécanique (10 ; 10') soutire de l'air de la cavité interne (62) de la paroi isolante (6).

## Patentansprüche

1. Elektrischer Schaltschrank (2; 2a; 2b; 2c) mit einer Wärmedämmung, wobei der elektrische Schaltschrank ein Gehäuse (4) definiert, um mindestens ein elektrisches Gerät aufzunehmen, wobei der elektrische Schaltschrank mindestens eine wärmedämmende Wand (6) aufweist, die auf einer Fläche (22; 24) des elektrischen Schaltschranks angebracht ist,
wobei die dämmende Wand einen hohlen inneren Hohlraum (62) aufweist,
**dadurch gekennzeichnet, dass** der elektrische Schaltschrank ferner aufweist:
eine mechanische Vorrichtung (10; 10') wie ein Kompressor oder eine Pumpe, die ausgelegt ist, um den Druck im Inneren des Hohlraums (62) zu ändern, wobei die mechanische Vorrichtung mit dem Hohlraum fluidisch verbunden ist,
mindestens eine Messvorrichtung (14), die ausgelegt ist, um eine Temperaturdifferenz zwischen dem Inneren des Schranks und außerhalb des Schranks zu bestimmen,
eine elektronische Steuervorrichtung (12), die ausgelegt ist, um die mechanische Vorrichtung (10; 10') derart zu steuern, dass der Druck im Innern des Hohlraums (62) in Abhängigkeit von der gemessenen Temperaturdifferenz geändert wird.

2. Elektrischer Schaltschrank (2; 2a; 2b; 2c) nach vorangehendem Anspruch, **dadurch gekennzeichnet, dass** die mechanische Vorrichtung (10; 10') ausgelegt ist, um ein Gas oder ein Gasgemisch aus dem inneren Hohlraum (62) aus- oder einzuleiten.

3. Elektrischer Schaltschrank (2; 2a; 2b; 2c) nach vorangehendem Anspruch, **dadurch gekennzeichnet, dass** die mechanische Vorrichtung (10, 10') ferner ausgelegt ist, um ein Gas oder ein Gasgemisch in den inneren Hohlraum (62) mit einem Druck über dem atmosphärischen Druck einzuleiten.

4. Elektrischer Schaltschrank (2; 2a; 2b; 2c) nach einem der vorangehenden Ansprüche, **dadurch gekennzeichnet, dass** die Messvorrichtung (14) einen ersten Temperatursensor (142) zum Messen der Temperatur außerhalb des elektrischen Schaltschranks und einen zweiten Temperatursensor (140) zum Messen der Temperatur im elektrischen Schaltschrank aufweist.

5. Elektrischer Schaltschrank (2; 2a; 2b; 2c) nach einem der vorangehenden Ansprüche, **dadurch gekennzeichnet, dass** die Messvorrichtung (14) einen Feuchtigkeitssensor (140) aufweist, der imstande ist, die relative Feuchtigkeit im Inneren des Gehäuses (4) zu messen und dass die Steuervorrichtung (12) ferner ausgelegt ist, um die mechanische Vorrichtung (10; 10') derart zu steuern, dass der Druck im Inneren des inneren Hohlraums (62) ebenfalls in Abhängigkeit von der gemessenen relativen Feuchtigkeit geändert wird.

6. Elektrischer Schaltschrank (2) nach einem der vorangehenden Ansprüche, **dadurch gekennzeichnet, dass** die dämmende Wand (6) auf einer oberen Fläche (22) des Schranks platziert ist, insbesondere um die obere Fläche mindestens zum Teil abzudecken.

7. Elektrischer Schaltschrank (2a) nach einem der Ansprüche 1 bis 6, **dadurch gekennzeichnet, dass** sich die dämmende Wand (6) einteilig über mindestens einen Teil des Umfangs des elektrischen Schaltschranks derart erstreckt, dass mehrere anliegende Flächen (22; 24) des elektrischen Schaltschranks bedeckt sind.

8. Elektrischer Schaltschrank (2b) nach einem der Ansprüche 1 bis 6, **dadurch gekennzeichnet, dass** der Schrank mindestens zwei wärmedämmende Wände (6) aufweist, die jeweils einer Fläche (22; 24) des elektrischen Schaltschranks zugeordnet sind, wobei die zwei dämmenden Wände durch einen Verbinder (8') verbunden sind, der die jeweiligen inneren Hohlräume (62) der dämmenden Wände fluidisch verbindet, wobei der eine der Hohlräume mit derselben mechanischen Vorrichtung (10) oder mit getrennten mechanischen Vorrichtungen fluidisch verbunden ist.

9. Elektrischer Schaltschrank (2c) nach einem der Ansprüche 1 bis 6, **dadurch gekennzeichnet, dass** der Schrank mindestens zwei wärmedämmende Wände (6) aufweist, die jeweils einer Fläche (22; 24) des elektrischen Schaltschranks zugeordnet sind, wobei die jeweiligen inneren Hohlräume (62) der dämmenden Wände jeweils mit einer mechanischen Vorrichtung (10; 10') fluidisch verbunden sind.

10. Elektrischer Schaltschrank (2; 2a; 2b; 2c) nach einem der Ansprüche 2 bis 9, **dadurch gekennzeichnet, dass** das in dem inneren Hohlraum (62) enthaltene Gas Luft ist.

11. Elektrischer Schaltschrank (2; 2a; 2b; 2c) nach einem der Ansprüche 2 bis 9, **dadurch gekennzeichnet, dass** das in dem inneren Hohlraum (62) enthaltene Gas ein Gasgemisch mit unterschiedlichen thermischen Konduktivitätskoeffizienten ist.

12. Verfahren zur Steuerung der Wärmedämmung für einen elektrischen Schaltschrank (2; 2a; 2b; 2c) nach einem der vorangehenden Ansprüche, **dadurch gekennzeichnet, dass** das Verfahren zur Steuerung der Dämmung die folgenden Schritte umfasst:
a) einen ersten Schritt (122), der darin besteht, Messungen von der Messvorrichtung (14) zu erfassen;
b) einen zweiten Schritt (124), der darin besteht, die Messungen mit der elektronischen Steuervorrichtung (12) zu analysieren und eine Antwort zu berechnen;
c) einen dritten Schritt (126), der darin besteht, Luft mit der mechanischen Vorrichtung (10; 10') aus dem inneren Hohlraum (62) der dämmenden Wand (6) aus- oder einzuleiten.

13. Verfahren zur Steuerung der Wärmedämmung nach vorangehendem Anspruch, **dadurch gekennzeichnet, dass** im zweiten Schritt (124), wenn die vom äußeren Sensor der Außentemperatur (142) gemessene Temperatur über einem ersten Grenzwert oder unter einem zweiten Grenzwert liegt, wobei der zweite Grenzwert strikt kleiner als der erste Grenzwert ist, die mechanische Vorrichtung (10; 10') dann im dritten Schritt (126) Luft aus dem inneren Hohlraum (62) der dämmenden Wand (6) ausleitet.

14. Verfahren zur Steuerung der Wärmedämmung nach einem der Ansprüche 12 oder 13, **dadurch gekennzeichnet, dass** im zweiten Schritt (124), wenn die vom äußeren Sensor der Außentemperatur (142) gemessene Temperatur zwischen dem ersten Grenzwert und dem zweiten Grenzwert liegt, wenn in einem ersten Unterschritt (130) die Außentemperatur über der Innentemperatur liegt, oder wenn in einem zweiten Unterschritt (136) Bedingungen festgestellt werden, die die Ausbildung von Kondensat im Gehäuse (4) begünstigen, die mechanische Vorrichtung (10; 10') dann im dritten Schritt (126) Luft aus dem inneren Hohlraum (62) der dämmenden Wand (6) ausleitet.

## Claims

1. An electrical cabinet (2; 2a; 2b; 2c) with thermal insulation, the electrical cabinet defining an enclosure (4) for receiving at least one electrical appliance, said electrical cabinet including at least one thermally insulating wall (6) mounted on a face (22; 24) of the electrical cabinet,
said insulating wall including a hollow inner cavity (62),
**characterized in that** the electrical cabinet further includes:
a mechanical device (10; 10'), such as a compressor or a pump, configured to modify the pressure inside said cavity (62), the mechanical device being fluidically connected to said cavity,
at least one measuring device (14), configured to determine a temperature difference between the inside of the cabinet and the outside of the cabinet,
an electronic control device (12), configured to control the mechanical device (10; 10') so as to modify the pressure inside said cavity (62) as a function of the measured temperature difference.

2. The electrical cabinet (2; 2a; 2b; 2c) according to the preceding claim, **characterized in that** the mechanical device (10; 10') is configured to withdraw or introduce a gas or a mixture of gases into the inner cavity (62).

3. The electrical cabinet (2; 2a; 2b; 2c) according to the preceding claim, **characterized in that** the mechanical device (10, 10') is further configured to introduce a gas or a mixture of gases into the inner cavity (62) at a pressure greater than atmospheric pressure.

4. The electrical cabinet (2; 2a; 2b; 2c) according to any one of the preceding claims, **characterized in that** the measuring device (14) includes a first temperature sensor (142) for measuring the temperature outside the electrical cabinet, and a second temperature sensor (140) for measuring the temperature inside the electrical cabinet.

5. The electrical cabinet (2; 2a; 2b; 2c) according to any one of the preceding claims, **characterized in that** the measuring device (14) includes a humidity sensor (140) able to measure the relative humidity inside the enclosure (4), and **in that** the control device (12) is further configured to control the mechanical device (10; 10') so as to modify the pressure inside the inner cavity (62) also as a function of the measured relative humidity.

6. The electrical cabinet (2) according to any one of the preceding claims, **characterized in that** the insulating wall (6) is placed on an upper face (22) of the cabinet, in particular to cover at least part of said upper face.

7. The electrical cabinet (2a) according to any one of claims 1 to 6, **characterized in that** the insulating wall (6) extends in a single piece over at least part of the periphery of the electrical cabinet, so as to cover several adjacent faces (22; 24) of the electrical cabinet.

8. The electrical cabinet (2b) according to any one of claims 1 to 6, **characterized in that** the cabinet includes at least two thermally insulating walls (6), each associated with a face (22; 24) of the electrical cabinet, the two insulating walls being connected by a connector (8') that fluidically connects the respective inner cavities (62) of said insulating walls, one of said cavities being fluidically connected to the same mechanical device (10) or to separate mechanical devices.

9. The electrical cabinet (2c) according to any one of claims 1 to 6, **characterized in that** the cabinet includes at least two thermally insulating walls (6), each associated with a face (22; 24) of the electrical cabinet, the respective inner cavities (62) of said insulating walls each being fluidically connected to a mechanical device (10; 10').

10. The electrical cabinet (2; 2a; 2b; 2c) according to any one of claims 2 to 9, **characterized in that** the gas contained in the inner cavity (62) is air.

11. The electrical cabinet (2; 2a; 2b; 2c) according to any one of claims 2 to 9, **characterized in that** the gas contained in the inner cavity (62) is a mixture of gases with different thermal conductivity coefficients.

12. A method for managing thermal insulation for an electrical cabinet (2; 2a; 2b; 2c) according to any one of the preceding claims, **characterized in that** the insulation management method comprises the following steps:
a) a first step (122) consisting in acquiring the measurements originating from the measuring device (14);
b) a second step (124) consisting in analyzing the measurements owing to the electronic control device (12) and calculating a response;
c) a third step (126) consisting in removing or introducing air in the inner cavity (62) of the insulating wall (6) owing to the mechanical device (10; 10').

13. The method for managing thermal insulation according to the preceding claim, **characterized in that** in the second step (124), when the temperature measured by the external sensor (142) for detecting the outside temperature is above a first threshold or below a second threshold, the second threshold being strictly below the first threshold, then in the third step (126), the mechanical device (10; 10') withdraws air from the inner cavity (62) of the insulating wall (6).

14. The method for managing thermal insulation according to any one of claims 12 or 13, **characterized in that** in the second step (124), when the temperature measured by the external sensor (142) for detecting the outside temperature is comprised between the first threshold and the second threshold, if, in a first sub-step (130), the outside temperature is above the inside temperature, or if, in a second sub-step (136), conditions favorable to the appearance of condensation in the enclosure (4) are detected, then in the third step (126), the mechanical device (10; 10') withdraws air from the inner cavity (62) of the insulating wall (6).
